# EUROPÄISCHE PATENTANMELDUNG

(11) **EP 3 842 567 A1**
(43) Veröffentlichungstag der Anmeldung: **30.06.2021**
(21) Anmeldenummer: 20000459.6
(22) Anmeldetag: 11.12.2020
(51) Int. Cl.: C23C 16/30, C23C 16/455, C30B 25/16, C30B 29/42, H01L 21/02

(54) **GASPHASENEPITAXIEVERFAHREN**

(30) Priorität: 20.12.2019 DE 102019008931
(71) Anmelder: AZUR SPACE Solar Power GmbH, 74072 Heilbronn (DE)
(72) Erfinder: Keller, Gregor, 74080 Heilbronn (DE); Wächter, Clemens, 74348 Lauffen am Neckar (DE); Wierzkowski, Thorsten, 74074 Heilbronn (DE)
(74) Vertreter: Koch Müller Patentanwaltsgesellschaft mbH

(57) **Zusammenfassung**

Gasphasenepitaxieverfahren mit dem Verfahrensschritt Aufwachsen einer III-V-Schicht mit einem sich von einer p-Dotierung zu eine n-Dotierung ändernden Dotierungsverlauf auf einer Oberfläche eines Substrats oder einer vorausgehenden Schicht in einer Reaktionskammer aus der Gasphase aus einem Epitaxie-Gasfluss aufweisend ein Trägergas, mindestens einen ersten Präkursor für ein Element aus der III. Hauptgruppe und mindestens einen zweiten Präkursor für ein Element aus der V. Hauptgruppe, wobei bei Erreichen einer ersten Aufwachshöhe mittels eines Verhältnisses eines ersten Massestroms des ersten Präkursors zu einem zweiten Massestrom des zweiten Präkursors in dem Epitaxie-Gasfluss ein erster Dotierungsausgangwert eingestellt wird und anschließend durch schrittweises oder kontinuierliches Ändern des Verhältnisses des ersten Massestroms zu dem zweiten Massestrom und durch schrittweises oder kontinuierliches Erhöhen eines Massestroms eines dritten Präkursors für einen n-Dotierstoff in dem Epitaxie-Gasfluss eine Dotierung der III-V-Schicht über eine Übergangsbereichsschicht mit einer Aufwachshöhe von mindestens 10 µm bis zu einem Erreichen eines n-Dotierungszielwerts geändert wird.

## Beschreibung

Die Erfindung betrifft ein Gasphasenepitaxieverfahren.

Es sind unterschiedliche Gasphasenepitaxie-Anlagen, z.B. von der Fa. Aixtron, zum epitaktischen Erzeugen von Halbleiterschichten bekannt.

Den Anlagen gemein ist, dass die epitaktischen Schichten aus der Gasphase auf einem in einer Reaktionskammer eingebrachten Substrat abgeschieden bzw. aufgewachsen werden. Hierzu wird die Reaktionskammer aufgeheizt und ein Epitaxie-Gasfluss in die Reaktionskammer eingeleitet.

Die Zusammensetzung des Gasflusses richtet sich nach der Art der zu wachsenden Schicht, wobei typischerweise Präkursoren, wie z.B. Arsin und/oder TMGa, die Elemente für die zu wachsende Halbleiterschicht liefern und für eine Dotierung der Schicht gegebenenfalls auch Präkursoren für einen Dotierstoff zugegeben werden. Die Präkursoren werden mittels eines Trägergases in die Reaktionskammer geleitet. Um die Zusammensetzung des Gasflusses zu kontrollieren werden typischerweise Massestromregler eingesetzt.

Zu beachten ist allerdings auch, dass aufgrund der Reaktorhistorie auch noch andere unerwünschte Elemente aus vorherigen Prozessen in der Reaktionskammer vorhanden sein können. Gerade für das Erzeugen niedrig dotierter Schichten kann dies problematisch werden.

Vor diesem Hintergrund besteht die Aufgabe der Erfindung darin, ein Verfahren anzugeben, das den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Gasphasenepitaxieverfahren mit dem Verfahrensschritt Aufwachsen einer III-V-Schicht mit einem sich von einer p-Dotierung zu einer n-Dotierung ändernden Dotierungsverlauf auf einer Oberfläche eines Substrats oder einer vorausgehenden Schicht bereitgestellt.

In einer Reaktionskammer wird aus der Gasphase aus einem Epitaxie-Gasfluss die III-V-Schicht aufgewachsen.

Der Epitaxie-Gasfluss weist ein Trägergas und mindestens einen ersten Präkursor für ein Element aus der III. Hauptgruppe und mindestens einen zweiten Präkursor für ein Element aus der V. Hauptgruppe auf.

Außerdem wird bei Erreichen einer ersten Aufwachshöhe mittels eines Verhältnisses eines ersten Massestroms des ersten Präkursors zu einem zweiten Massestrom des zweiten Präkursors in dem Epitaxie-Gasfluss ein erster Dotierungsausgangswert eingestellt.

Anschließend wird durch schrittweises oder kontinuierliches Ändern des Verhältnisses des ersten Massestroms zu dem zweiten Massestroms und durch schrittweises oder kontinuierliches Erhöhen eines Massestroms eines dritten Präkursors für einen n-Dotierstoff in dem Epitaxie-Gasfluss eine Dotierung der III-V-Schicht über eine Übergangsbereichsschicht mit einer Aufwachshöhe von mindestens 10 µm bis zu einem Erreichen eines n-Dotierungszielwerts geändert.

Es versteht sich, dass eine III-V-Schicht mindestens eine Komponente oder auch mehrere Komponenten der III. Hauptgruppe, z.B. Aluminium oder Gallium und mindestens eine Komponente oder mehrere Komponenten der V. Hauptgruppe, z.B. Indium oder Arsen oder Phosphor aufweist.

Als Präkursor werden Moleküle bezeichnet, welche als Ausgangsprodukt für das epitaktische Wachstum dienen. Ein Präkursor ist entsprechend ein Molekül bestehend aus einem aufzuwachsenden Element, z.B. einem Element der III. oder V. Hauptgruppe oder einem Dotierstoff, und mindestens einem weiteren Element.

Insbesondere bei metallorganischen Präkursoren, z.B. TMGa, ist ein weiteres Element Kohlenstoff, welcher während des Aufwachsens freigesetzt wird und dadurch zusätzlich als Dotierstoff wirkt.

Ein Dotieren einer Schicht mittels des Kohlenstoffs eines metallorganischen Präkursors wird als Autodoping bezeichnet, während das Zugeben eines Präkursors für einen Dotierstoff zu dem Epitaxie-Gasfluss als direktes Dotieren oder direkte Dotierung bezeichnet wird.

Insbesondere in dem Fall des Autodopings Ist die Höhe sowie die Art der Dotierung einer III-V-Schicht von dem Mengenverhältnis zwischen dem Element bzw. den Elementen der III. Hauptgruppe und dem Element bzw. den Elementen der V. Hauptgruppe in der Reaktionskammer abhängig.

Je nach Art und Größe der verwendeten Gasphasen-Anlage schwankt das V-III-Mengenverhältnis innerhalb der Reaktionskammer, d.h. an unterschiedlichen Orten weist der ankommende Gasfluss unterschiedliche V-III-Mengenverhältnisse auf. Solche Schwankungen können im Bereich eines einzelnen Substrats und/oder über mehrere Substrate hinweg auftreten.

Es versteht sich, dass das Ändern des Massestroms oder das Ändern des Verhältnisses von zwei unterschiedlichen Masseströmen äquivalent mit dem Ändern eines entsprechen Partialdrucks bzw. Partialdruckverhältnisses bzw. grundsätzlich äquivalent mit jeder Mengenkontrolle/-änderung ist.

Es versteht sich auch, dass das Einstellen der genannten Dotierungswerte während des Aufwachsens geschieht bzw. dass durchgehend aufgewachsen und während des Wachsens bzw. Abscheidens die Masseströme geändert werden, wobei eine schrittweise Änderung eines Massestroms oder eines Massestromverhältnisses auch zu einer entsprechend schrittweisen, z.B. treppenförmige, Änderung der Dotierung bzw. ein kontinuierliches Ändern von Masseströmen zu einer entsprechend kontinuierlichen, z.B. rampenförmigen, Änderung der Dotierung in der gewachsenen Schicht führt.

Dabei schließen sich die einzelnen Schritte, also das Ändern bis zu dem Dotierungszielwert an das Einstellen des ersten Dotierungsausgangswerts, entweder zeitlich direkt aneinander an oder sie finden zeitlich verzögert statt, wobei sich bei einer zeitlichen Verzögerung und ohne weitere Änderungen an dem Epitaxie-Gasfluss entsprechend noch eine Schicht mit konstanter Dotierung ausbildet.

Zuerst wird der erste Dotierungsausgangswert eingestellt, wobei die Dotierung durch Autodoping, also über das V-III-Verhältnis eingestellt wird. Dem Epitaxie-Gasfluss wird dabei kein weiterer Präkursors für einen p-Dotierstoff zugegeben.

Durch die Änderung V / III Verhältnisses und / oder des Masseflusses des dritten Präkursors während des Wachsens der Übergangsbereichsschicht lässt sich ein reproduzierbarer Verlauf im Bereich des p-n Übergangs erzielen. Eine unerwünschte Ausbildung von seriellen mehrfach p/n Übergängen lassen sich auf den Halbleiterscheiben ebenso wie eine Ausbildung von lokalen Unterschieden in den Dotierstoffverläufen zuverlässig unterdrücken.

Ein weiterer Vorteil ist, dass sich eine Kreuzkontamination, beispielsweise aus der Belegung der Reaktorkammer aus vorangegangenen Epitaxiephasen, zuverlässig und wirkungsvoll kompensieren lässt und sich Schichten mit niedrigen Dotierungen unterhalb von 5•10¹⁵ cm⁻³ und insbesondere p / n Übergänge ausgehend von einer n-Dotierung zuverlässig herstellen lassen.

Ausgehend von einem konstanten V / III Verhältnisses während des Wachsens der Übergangsbereichsschicht von wenigstens 10 µm, lassen sich die bisherigen auf den Halbleiterscheiben stark schwankenden Sperrspannungen, mit Unterschieden von mehr als 20V oder mehr als 100 V, reduzieren.

Alternativ weist der Epitaxie-Gasfluss eine gegebenenfalls geringe Menge eines Präkursors für einen p-Dotierstoff auf, die bei dem Einstellen der Dotierung über das V-III-Verhältnis berücksichtigt wird.

Die p-Dotierung des vorausgehenden Bereichs der III-V-Schicht ist gegebenenfalls höher. Beispielsweise weist eine vorab gewachsene Schicht oder das Substrat eine p-Dotierung mit abnehmendem Verlauf auf, wobei bei der ersten Aufwachshöhe der erste Dotierungsausgangswert erreicht ist.

Alternativ weist die vorausgehende Schicht oder das Substrat bereits eine dem ersten Dotierungsausgangswert entsprechende Dotierung auf, so dass das Einstellen bei Erreichen der ersten Aufwachshöhe auf einem Beibehalten der Einstellungen entspricht.

In einer weiteren Alternative weist die vorab gewachsene Schicht oder das Substrat eine höhere p-Dotierung auf, wobei die p-Dotierung sprunghaft, schrittweise oder kontinuierlich bis zu der ersten Aufwachshöhe auf den ersten Ausgangswert gesenkt wird.

Auch versteht es sich, dass der Epitaxie-Gasfluss auch bei dem Einstellen des ersten Dotierungsausgangswerts bereits einen gegebenenfalls geringen Massefluss des dritten Präkursors aufweisen kann, wobei die Präsenz des n-Dotierstoffs mittels des V-III-Verhältnisses und/oder des Massestroms des weiteren Präkursors entsprechend ausgeglichen wird.

Die anschließende rampen- oder treppenförmige Änderung der Dotierung über die Übergangsbereichsschicht erfolgt durch ein Ändern des Verhältnisses des ersten Massestroms zu dem zweiten Massestrom und durch ein Erhöhen des Massenstroms des dritten Präkursors, z.B. Silan.

Es versteht sich, dass das Verändern des Verhältnisses von erstem zu zweitem Massestrom und das Erhöhen des Massestroms des dritten Präkursors parallel, d.h. gleichzeitig, und/oder schrittweise abwechselnd oder auch vollständig nacheinander erfolgen.

Als Trägergas für den Epitaxie-Gasfluss eignet sich beispielsweise H₂ oder N₂.

Aufgrund von örtlichen Unterschieden im V-III-Verhältnis und/oder von Hintergrunddotierungen kann ein sprunghafter p-n Übergang, also eine Änderung der Dotierung von p nach n ohne Zwischenschritte und über eine sehr geringe Aufwachshöhe, z.B. höchstens einige Nanometer, gerade bei niedrigen Dotierungen zu sehr unterschiedlichen Sperrspannungen über einzelne Halbleiterscheiben und/oder mehrere Halbleiterscheiben hinweg führen.

Anders ausgedrückt, Schwankungen des V-III-Verhältnisses über die Halbleiterscheibe resultieren in unterschiedlichen lokalen Dotierungen und wirken sich gerade bei niedrigen Dotierungen besonders stark aus.

Ein Vorzug des Verfahrens besteht darin, dass sich das Gasphasenepitaxieverfahren unter Nutzung eines geringen Flusses des zweiten Präkursors für die Gruppe V durchführen lässt. Wird insbesondere für den zweiten Präkursor Arsin oder TGMa verwendet, lassen sich mittels eines geringen Flusses des zweiten Präkursors die Herstellungskosten deutlich senken und die Umweltfreundlichkeit des Herstellungsprozesses stark erhöhen.

Durch die schrittweise oder kontinuierliche Änderung der Dotierung über die Dicke einer Übergangsbereichsschicht bei einem konstanten oder nahezu konstanten V/III Verhältnis der Masseströme, wird dagegen ein über die gesamte Reaktionskammer hinweg reproduzierbarer Verlauf des p-n Übergangs erreicht auf der Halbleiterscheiber erreicht.

Die Unterschiede im ankommenden Gasfluss wirken sich lediglich auf die absolute Wachstumstiefe des Übergangs aus, wobei die Unterschiede in der absolute Wachstumstiefe eine geringeren Einfluss auf die erreichten Sperrspannungen als ein nicht reproduzierbarer Dotierungsverlauf des p-n Übergangs.

Mittels eines Massestromreglers für den Massestrom des dritten Präkursors sowie Massestromreglern für die Masseströme des ersten und zweiten Präkursors lässt sich der erfindungsgemäße treppen- oder rampenförmige Übergangsbereich auf einfache und zuverlässige Weise kontrollieren bzw. umsetzen.

Ein weiterer Vorteil der Erfindung ist somit, dass auf einfache und reproduzierbare Weise ohne besondere Anforderungen an die verwendete Gasphasen-Epitaxie-Anlage zuverlässig hohe Spannungsfestigkeiten des p n Übergangs oberhalb 200 V erreicht lassen.

Gemäß einer ersten Ausführungsform ist der erste Dotierungsausgangswert ein p-Dotierungsausgangswert und beträgt höchstens 5•10¹⁶ cm⁻³ oder höchstens 1•10¹⁶ cm⁻³ oder höchstens 1•10¹⁵ cm⁻³ oder höchstens 50•10¹⁴ cm⁻³. Alternativ ist der erste Dotierungsausgangswert ein n-Dotierungsausgangswert und beträgt höchstens 1•10¹⁵ cm⁻³ oder höchstens 5•10¹⁴ cm⁻³ oder höchstens 1•10¹⁴ cm⁻³. Als Startpunkt für die Rampe oder Treppe wird somit eine niedrige p-Dotierung oder sogar schon eine sehr niedriger n-Dotierungswert gewählt.

In einer anderen Ausführungsform beträgt der n-Dotierungszielwert höchstens 5•10¹⁶ cm⁻³ oder höchstens 10•10¹⁶ cm⁻³ oder höchstens 1•10¹⁵ cm⁻³ oder höchstens 5•10¹⁴ cm⁻³. Die Rampe oder Treppe überstreicht somit einen Bereich niedriger Dotierungswerte.

In einer Weiterbildung beträgt die Aufwachshöhe des Übergangsbereichs mindestens 30 µm oder mindestens 60 µm.

Gemäß einer anderen Weiterbildung wird die Dotierung über die Übergangsbereichsschicht über je 5 µm der Aufwachshöhe um höchstens 1•10¹³ cm⁻³ geändert und/oder die Dotierung wird über die Übergangsbereichsschicht in mindestens vier Schritten, z.B. vier Stufen, geändert.

In einer anderen Ausführungsform ist das Element der III. Hauptgruppe Gallium und das Element der V. Hauptgruppe Arsen und/oder der dritte Präkursor ist Monosilan.

Gemäß einer weiteren Ausführungsform wird der erster Dotierungsausgangwert ausgehend von einem zweiten p-Dotierungsausgangswert durch ein sprunghaftes Ändern des Verhältnisses des ersten Massestroms zu dem zweiten Massestrom eingestellt wird.

Die Dotierung wird somit sprunghaft in den Übergangsbereich hinein geändert. Der zweite p-Dotierungsausgangswert beträgt gemäß einer Weiterbildung höchstens 5•10¹⁶ cm⁻³ oder höchstens 1•10¹⁶ cm⁻³.

In einer anderen Ausführungsform wird die Dotierung der III-V-Schicht in einem der ersten Aufwachshöhe vorausgehenden Schichtbereich durch kontinuierliches und/oder schrittweises Ändern des Verhältnisses des ersten Massestroms zu dem zweiten Massestrom von einem p-Dotierungsstartwert von mindestens 5•10¹⁶ cm⁻³ oder mindestens 1•10¹⁷ cm⁻³ auf den ersten Dotierungsausgangwert oder auf einen zweiten Dotierungsausgangswert gesenkt.

Alternativ weist ein der ersten Aufwachshöhe vorausgehender Schichtbereich einen konstanten p-Dotierungswert auf, wobei der p-Dotierungswert entweder dem ersten Dotierungsausgangswert entspricht oder die Dotierung bei Erreichen der ersten Aufwachshöhe von dem p-Dotierungswert sprunghaft auf den ersten Dotierungsausgangswert abgesenkt wird.

Gemäß einer weiteren Weiterbildung wird nach dem Erreichen des n-Dotierungszielwerts über eine Aufwachshöhe von mindestens 10 µm mit den Einstellungen für den n-Dotierungszielwert weiter aufgewachsen.

Alternativ wird nach dem Erreichen des n-Dotierungszielwerts über eine Aufwachshöhe ein weiterer n-Dotierungszielwert durch sprunghaftes Ändern des dritten Massestroms und/oder durch sprunghaftes Ändern des Verhältnisses des ersten Massestroms zu dem zweiten Massestrom eingestellt, wobei der weitere n-Dotierungszielwert größer ist als der n-Dotierungszielwert.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: einen Querschnitt von in einer Reaktionskammer angeordneten Substraten,
- Figur 2: ein Zusammenhang zwischen einer Dotierung und einem Verhältnis von Elementen der V. Hauptgruppe zu Elementen der III. Hauptgruppe während eine epitaktischen Wachstums,
- Figur 3: einen Dotlerstoffkonzentrationsverlauf über eine gewachsene III-V-Schicht gemäß einer ersten erfindungsgemäßen Ausführungsform des Gasphasenepltaxieverfahrens,
- Figur 4: einen Dotierstoffkonzentrationsverlauf über eine gewachsene III-V-Schicht gemäß einer zweiten erfindungsgemäßen Ausführungsform des Gasphasenepitaxieverfahrens.

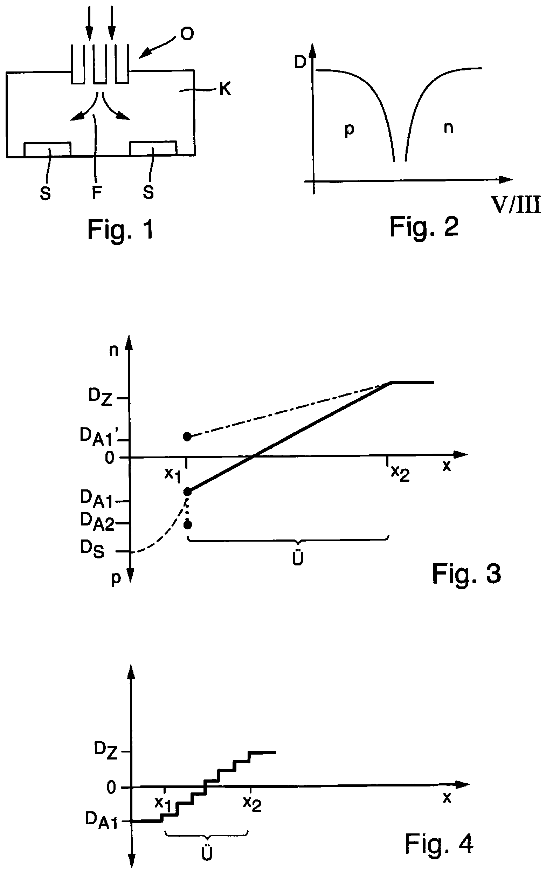

Die Abbildung der Figur 1 zeigt schematisch einen Querschnitt einer Reaktorkammer K einer Gasphasenepitaxie-Anlage. Auf einem Boden der Reaktorkammer K sind Substrate S angeordnet. Außerdem weist die Reaktorkammer K ein Gaseinlassorgan O auf, durch welches der Epitaxie-Gasfluss F in die Reaktorkammer K eingeleitet wird.

Der Epitaxie-Gasfluss F weist ein Trägergas, mindestens einen ersten metallorganischen Präkursor für ein Element der III. Hauptgruppe, z.B. TMGa, einen zweiten Präkursor für ein Element der V. Hauptgruppe, z.B. Arsin, und zumindest ab einer ersten Aufwachshöhe x1 einen dritten Präkursor für einen n-Dotierstoff, z.B. Silan, auf.

Das Gaseinlassorgan O weist mehrere in der Reaktorkammer K endende Leitungen auf, durch welche jeweils eine oder mehrere Komponenten des Epitaxie-Gasflusses F zu der Reaktorkammer K geleitet werden.

In der Abbildung der Figur 2 ist in einem Diagramm die Abhängigkeit der Dotierung von einem Mengenverhältnis der Elemente der V. und III. Hauptgruppe dargestellt. Insbesondere wird deutlich, dass nicht nur die Höhe einer Dotierung, sondern auch die Art der Dotierung, also n oder p, durch das V-III-Verhältnis, also das Mengenverhältnis in dem Gasfluss, eingestellt werden kann.

Andererseits wird deutlich, dass Schwankungen des V-III-Verhältnisses über einen Halbleiterscheiben bzw. ein Substrat in unterschiedlichen Dotierungen resultieren und sich solche Schwankungen gerade bei niedrigen Dotierungen besonders stark auswirken.

Ein Vorzug dieser Ausgestaltung besteht darin, dass das Gasphasenepitaxieverfahren unter Nutzung eines geringen Flusses des zweiten Präkursors für die Gruppe V durchführen lässt. Insbesondere wird für den zweiten Präkursor Arsin oder TGMa verwendet, lassen sich mittels eines geringen Flusses des zweiten Präkursors die Herstellungskosten deutlich senken und die Umweltfreundlichkeit des Herstellungsprozesses stark erhöhen.

Eine erste Ausführungsform des erfindungsgemäßen Gasphasenepitaxieverfahrens ist in der Abbildung der Figur 3 anhand eines Verlaufs der Dotierung D über eine Aufwachshöhe x veranschaulicht.

Zuerst bzw. bei einer ersten Aufwachshöhe x1 wird ein erster p-dotierter Dotierungsausgangswert DA1 allein mittels des Verhältnisses eines ersten Massestroms des ersten Präkursors, z.B. TMGa, zu einem zweiten Massestrom des zweiten Präkursor, z.B. Arsin, in dem Epitaxie-Gasfluss F, d.h. insbesondere ohne Zugabe eines weiteren Massestroms eines weiteren Präkursors für einen p-Dotierstoff, z.B. Kohlenstofftetrabromid, zu dem Epitaxie-Gasfluss F eingestellt. Auch ein dritter Massestrom des dritten Präkursors für den n-Dotierstoff beträgt Null.

Anschließend wird der dritte Massestrom des dritten Präkursors, z.B. Silan, zugegeben bzw. langsam und kontinuierlich über eine Übergangsbereichsschicht Ü kontinuierlich aufgedreht und gleichzeitig das Verhältnis des ersten Massestroms zu dem zweiten Massestrom verändert, bis bei einer Schichtdicke von x₂ ein n-Dotierungszielwert DZ erreicht ist und sich zwischen dem ersten Dotierungsausgangswert und dem n-Dotierungszielwert ein rampenförmiger Dotierungsverlauf ausgebildet hat.

Es versteht sich, dass sich die Übergangsbereichsschicht Ü von der ersten Aufwachshöhe x₁ bis hin zur zweiten Aufwachshöhe x₂ erstreckt.

Anschließend wird der Epitaxie-Gasfluss F über einen weiteren Bereich der Aufwachshöhe x nicht weiter verändert, so dass die Dotierung der sich anschließenden III-V-Schicht konstant ist.

Alternativ wird als erster Dotierungsausgangswert DA1' ein niedrig n-dotierter Wert eingestellt. Der entsprechende Dotierungsverlauf ist strichpunktiert dargestellt.

Gemäß einer Weiterbildung wird der ersten Dotierungsausgangswert DA1 durch eine sprunghafte Änderung des Verhältnisses des ersten Massestroms zu dem zweiten Massestrom eingestellt, so dass sich die Dotierung der III-V-Schicht an oder vor der ersten Aufwachshöhe x₁ von einem zweiten p-Dotierungsausgangswert DA2 sprunghaft auf den ersten Dotierungsausgangswert DA1 reduziert (gepunktet dargestellt).

Alternativ reduziert sich die Dotierung der III-V-Schicht von einem Dotierungsstartwert DS bis zu der ersten Aufwachshöhe kontinuierlich bis auf den ersten Dotierungsausgangswert DA1 (gestrichelt dargestellt).

In der Abbildung der Figur 4 ist eine weitere Ausführungsform des erfindungsgemäßen Gasphasenepitaxieverfahrens anhand des Dotierungsverlaufs D veranschaulicht, wobei im Folgenden nur die Unterschiede zu der Abbildung der Figuren 3 erläutert werden.

Die Änderung der Dotierung von dem n-Dotierungsausgangswert DA1 zu dem p-Dotierungszielwert DZ erfolgt in mehreren Schritten, so dass sich ein treppenförmiger Verlauf der Dotierung über die Übergangsbereichsschicht Ü einstellt.

## Patentansprüche

1. Gasphasenepitaxieverfahren mit dem Verfahrensschritt:
- Aufwachsen einer III-V-Schlcht mit einem sich von einer p-Dotierung zu eine n-Dotierung ändernden Dotierungsverlauf auf einer Oberfläche eines Substrats oder einer vorausgehenden Schicht in einer Reaktionskammer (K) aus der Gasphase aus einem Epitaxie-Gasfluss (F) aufweisend ein Trägergas, mindestens einen ersten Präkursor für ein Element aus der III. Hauptgruppe und mindestens einen zweiten Präkursor für ein Element aus der V. Hauptgruppe, wobei
- bei Erreichen einer ersten Aufwachshöhe (x1) mittels eines Verhältnisses eines ersten Massestroms des ersten Präkursors zu einem zweiten Massestrom des zweiten Präkursors in dem Epitaxie-Gasfluss (F) ein erster Dotierungsausgangswert (DA1) eingestellt wird und
- anschließend durch schrittweises oder kontinuierliches Ändern des Verhältnisses des ersten Massestroms des ersten Präkursors zu dem zweiten Massestroms des zweiten Präkursors und durch schrittweises oder kontinuierliches Erhöhen eines Massestroms eines dritten Präkursors für einen n-Dotierstoff in dem Epitaxie-Gasfluss eine Dotierung (D) der III-V-Schicht über eine Übergangsbereichsschicht (Ü) mit einer Aufwachshöhe von mindestens 10 µm bis zu einem Erreichen eines n-Dotierungszielwerts (DZ) geändert wird.

2. Gasphasenepitaxieverfahren nach Anspruch 1, **dadurch gekennzeichnet, dass** der erste Dotierungsausgangswert (DA1) ein p-Dotierungsausgangswert ist und höchstens 5•10¹⁶ cm⁻³ oder höchstens 1•10¹⁶ cm⁻³ oder höchstens 1•10¹⁵ cm⁻³ oder höchstens 5•10¹⁴ cm⁻³ beträgt.

3. Gasphasenepitaxieverfahren nach Anspruch 1, **dadurch gekennzeichnet, dass** der erste Dotierungsausgangswert (DA1) ein n-Dotierungsausgangswert ist und höchstens 1•10¹⁵ cm⁻³ oder höchstens 5•10¹⁴ cm⁻³ oder höchstens 1•10¹⁴ cm⁻³ beträgt.

4. Gasphasenepitaxieverfahren nach einem der vorstehenden Ansprüche, **dadurch gekennzeichnet, dass** der n-Dotierungszielwert (DZ) höchstens 5•10¹⁶ cm⁻³ oder höchstens 1•10¹⁶ cm⁻³ oder höchstens 1•10¹⁵ cm⁻³ oder höchstens 5•10¹⁴ cm⁻³ beträgt.

5. Gasphasenepitaxieverfahren nach einem der vorstehenden Ansprüche, **dadurch gekennzeichnet, dass** die Aufwachshöhe des Übergangsbereichs mindestens 30 µm oder mindestens 60 µm beträgt.

6. Gasphasenepitaxieverfahren nach einem der vorstehenden Ansprüche, **dadurch gekennzeichnet, dass** die Dotierung (D) über die Übergangsbereichsschicht (Ü) über je 5 µm der Aufwachshöhe (x) um höchstens 1•10¹³ cm⁻³ geändert wird.

7. Gasphasenepitaxieverfahren nach einem der vorstehenden Ansprüche, **dadurch gekennzeichnet, dass** die Dotierung (D) über die Übergangsbereichsschicht (Ü) in mindestens vier Schritten geändert wird.

8. Gasphasenepitaxieverfahren nach einem der vorstehenden Ansprüche, **dadurch gekennzeichnet, dass** das Element der III. Hauptgruppe Gallium und das Element der V. Hauptgruppe Arsen ist.

9. Gasphasenepitaxieverfahren nach einem der vorstehenden Ansprüche, **dadurch gekennzeichnet, dass** der dritte Präkursor Monosilan ist.

10. Gasphasenepitaxieverfahren nach einem der vorstehenden Ansprüche, **dadurch gekennzeichnet, dass** der erster Dotierungsausgangwert (DA1) ausgehend von einem zweiten p-Dotierungsausgangswert (DA2) durch ein sprunghaftes Ändern des Verhältnisses des ersten Massestroms zu dem zweiten Massestrom eingestellt wird.

11. Gasphasenepitaxieverfahren nach Anspruch 10, **dadurch gekennzeichnet, dass** der zweite p-Dotierungsausgangswert (DA2) höchstens 5•10¹⁶ cm⁻³ oder höchstens 1•10¹⁶ cm⁻³ beträgt.

12. Gasphasenepitaxieverfahren nach einem der vorstehenden Ansprüche, **dadurch gekennzeichnet, dass** die Dotierung (D) der III-V-Schicht in einem der ersten Aufwachshöhe (x1) vorausgehenden Schichtbereich durch kontinuierliches und/oder schrittweises Ändern des Verhältnisses des ersten Massestroms zu dem zweiten Massestrom von einem p-Dotierungsstartwert von mindestens 5•10¹⁶ cm⁻³ oder mindestens 1•10¹⁷ cm⁻³ auf den erster Dotierungsausgangwert (DA1) oder auf einen zweiten Dotierungsausgangswert (DA2) gesenkt wird.

13. Gasphasenepitaxieverfahren nach einem der vorstehenden Ansprüche, **dadurch gekennzeichnet, dass** nach dem Erreichen des n-Dotierungszielwerts (DZ) über eine Aufwachshöhe (x) von mindestens 10 µm mit den Einstellungen für den n-Dotierungszielwert (DZ) weiter aufgewachsen wird.

14. Gasphasenepitaxieverfahren nach einem der vorstehenden Ansprüche, **dadurch gekennzeichnet, dass** nach dem Erreichen des n-Dotierungszielwerts (DZ) über eine Aufwachshöhe ein zweiter n-Dotierungszielwert durch sprunghaftes Ändern des dritten Massestroms und/oder durch sprunghaftes Ändern des Verhältnisses des ersten Massestroms zu dem zweiten Massestrom eingestellt wird, wobei der zweite n-Dotierungszielwert größer als der n-Dotierungszielwert (DZ) ist.
